Europäisches Patentamt

European Patent Office

Office européen des brevets

(19)

(11) **EP 1 120 835 A2**

(12) **EUROPEAN PATENT APPLICATION**

(43) Date of publication:
**01.08.2001 Bulletin 2001/31**

(51) Int Cl.7: **H01L 29/78**, H01L 29/417,
H01L 21/768

(21) Application number: **01101227.5**

(22) Date of filing: **19.01.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **26.01.2000 US 491373**<br><br>(71) Applicant: **Siliconix incorporated**<br>Santa Clara,CA 95054-1595 (US) | (72) Inventors:<br>• **Bhalla, Anup**<br>Santa Clara, CA 95050 (US)<br>• **Kim, Paul**<br>Santa Clara, CA 95051 (US)<br>• **Korec, Jacek, Dr.**<br>San Jose, CA 95120 (US)<br><br>(74) Representative: **Kolb, Georg**<br>DaimlerChrysler AG,<br>Postfach 35 35<br>74025 Heilbronn (DE) |

(54) **MOSFET and method of manufacturing the same**

(57)  A MOSFET is fabricated in a silicon-on-insulator (SOI) chip having a relatively thin active layer (206) overlying an oxide intermediate layer (204) and a substrate layer (202). The MOSFET is a lateral device wherein contact is made to the source (212) from the back side of the chip by means of a conductive plug (246) that extends from the surface of the active layer through the active layer and the oxide layer (204) into the substrate (202). To improve its performance at high frequencies, the MOSFET may contain a silicon-germanium multilayer (230) structure formed on the active layer and its polysilicon gate (210) may contain an overlying silicide layer (234). The gate oxide may be made thicker at the drain end of the gate to protect against the peak electric field that typically occurs in this region.

FIG. 2

EP 1 120 835 A2

**Description**

FIELD OF THE INVENTION

This invention relates to power MOSFETs and in particular to power MOSFETs that are suitable for high frequency signal amplification and switching.

BACKGROUND OF THE INVENTION

High efficiency, high gain power transistors are increasingly required for radio frequency (RF) applications in portable communications products and fixed base stations. For small signals, silicon MOSFETs currently available on the market can operate at frequencies as high as 2 Ghz. However, the current carrying capability and gain of these MOSFETs are quite low. For example, the current capability of lightlydoped-drain MOSFETs (LDMOS-transistors) used for these purposes hardly exceeds 0.3 A/mm, and their maximum transconductance remains below 50 mS/mm (in each case the figures are per millimeter of gate width). The industry requires MOSFETs having a higher current capacity and transconductance that can be produced at a low cost.

Similarly, MOSFETs that are used in DC/DC converters need to switch large load currents at high frequencies. Typically, these MOSFETs have high switching power losses, and these losses increase with frequency. For this reason, the switching frequency of the transistors remains below 500 kHz. Higher operating frequencies would be beneficial for portable electronics products as well as desk-top computers, because higher frequencies would permit a smaller volume filter components and provide a higher efficiency of power conversion. In particular, transistors with a low on-resistance (Rds,on), minimized input capacitance (Ciss) and minimum output capacitance (Coss) are required. For purposes of comparison a useful figure of merit can be calculated by multiplying the specific resistance (Rds) and the corresponding gate charge (Qg) of a device at a particular gate voltage, a lower figure of merit being preferable. For power transistors currently on the market, this figure of merit is usually higher than 200 m$\Omega$ nC.

Thus both linear signal amplification and powerswitching applications require MOSFETs that have a low resistance, high transconductance, minimal internal capacitances (input and output), and a high power density.

For high-frequency operation in DC/DC converters, two types of power MOSFETs are currently competing in the marketplace: MOSFETs with a trenched gate (TMOSFETs) and planar MOSFETs having a vertical current flow (VDMOS). Whereas the TMOSFET has a very high channel density and a resultant low on-resistance, it suffers from a high drain-to-gate capacitance (Cdg), which increases both its input and output capacitance. It is widely accepted that the vertical DMOS structure is better for high-frequency DC/DC converter operation. (See, e.g., R. Sodhi et al., "Integrated Design Environment for DC/DC Converter FET Optimization", Proceedings of the International Symposium on Power Semiconductor Devices and ICs (ISPSD) 1999, pages 241-244)

The switching frequency of DC/DC converters can be increased up to the range of a few Mhz only if the supply voltage is reduced to below 10 V. In this voltage range, a lateral lightly-doped drain MOSFET (LDD-MOSFET) offers the best performance. (See, e.g., N.X. Sun et al., "0.35$\mu$m, 43$\mu\Omega$cm$^2$, 6$\mu\Omega$ Power MOSFET to Power Future Microprocessor", Proceedings of the ISPSD (1999), pages 77-80) However, the topologies of existing DC/DC converters use transistors having a breakdown voltage of 30 V and do not accept low-voltage switches because of the high level of converted energy and possible voltage spikes.

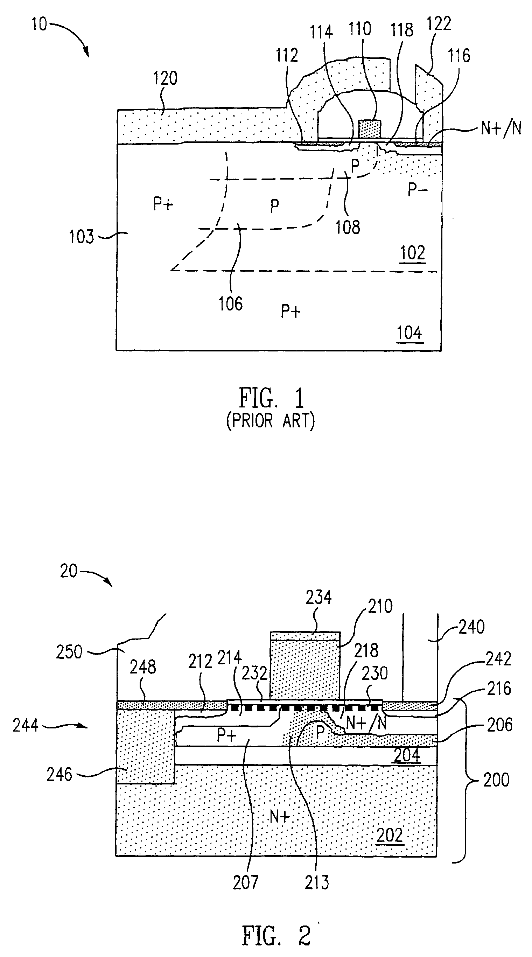

For high-frequency operation of a DC/DC converter in a voltage range up to 60 V, a lateral current flow MOSFET of the kind shown in **Fig. 1** is preferred. MOSFET 10 is fabricated in a P- epitaxial (epi) layer 102 that is grown on a P+ substrate 104. A P+ isolation sinker 103 extends from the surface of epi layer 102 to the P+ substrate 104. MOSFET 10 also includes a P enhancement region 106 and a P-body 108. A gate electrode 110 overlies a channel region within P-body 108. The source and drain regions 112, 116 include lightly-doped portions 114, 118. Metal layer 120 contacts drain region 114, and metal layer 122 contacts source region 116. A portion of metal layer 120 extends over gate electrode 110 to minimize the gate-drain capacitance (Cgd) by means of a Faradayshielding effect. (See, G. Ma et al., "High Efficiency LDMOS Power FET for Low Voltage Wireless Communications", Proceedings of International Electron Devices Meeting (IEDM) 1996, pages 91-94) Source region 116 can be contacted from the back side of the substrate to minimize the parasitic inductance and capacitance in the structure. This is especially important if the wire bond technique is used in assembling the device into a package.

Using the transistor of **Fig. 1** with a gate width of 0.6 $\mu$m, a small signal amplification at frequencies up to 2 GHz is possible.

The main drawbacks of the transistor shown in **Fig. 1** are its high manufacturing cost, limited currentcarrying capability, and large cell pitch. The high cost is due to the many steps required to manufacture the device. The large cell pitch is due mainly to the need to diffuse a deep sinker through a thick epi layer. The pitch can be reduced somewhat by using the technique shown in U.S. Patent No. 5,869,875, wherein a trench is etched partially through the epi layer, allowing contact to be made with the substrate by means of a relatively shallow sinker.

MOSFETs have been manufactured in silicon-on-insulator (SOI) substrates to minimize their internal capacitances. C.T. Nguyen et al., "Quasi-SOI MOSFETs Using Selective Epitaxy and Polishing", Proceedings of International Electron Devices Meeting, 1992, pages 341-344, teach a device wherein a key feature is "the placement of the drain and drain-side channel over oxide, while keeping the source and source-side channel connected to the substrate". This structure is made possible by a combination of selective epitaxial growth and chemo-mechanical polishing techniques to define the active area of the transistor. The transistor itself is placed in a thin semiconductor film created by a lateral overgrowth of an epitaxial layer that is grown in a "seed hole" etched into a field oxide film deposited on a silicon substrate. According to the authors, the resulting "quasi-SOI" device provides "reduced drain-bulk capacitance, improved sub-threshold swing, and increased breakdown voltage over both bulk and complete SOI counterparts." However, these improvements have been shown only on small signal transistors and have not yet been applied to power devices. Also, the suggested manufacturing technique using a selective epitaxy is expensive and does not readily permit the production of large area devices with uniform electrical behavior.

SUMMARY OF INVENTION

A MOSFET according to this invention is superior to previous power devices because it provides a better maximum current and transconductance for linear signal amplification and a lower product of on-resistance and gate charge for high-frequency switching.

The MOSFET of this invention comprises a sandwich that includes an active semiconductive layer of a first conductivity type (typically silicon), an insulating layer (typically silicon dioxide), and a semiconductor substrate of a second conductivity type (typically silicon), the insulating layer being interposed between the active layer and the substrate; a source region and a drain region formed adjacent a surface of the active layer, the source and drain regions being of the second conductivity type, a channel region being interposed between the source and drain regions; a gate overlying the channel region, the gate being separated from the channel region by a gate insulating layer (typically silicon dioxide); and a trench extending from the surface of the active layer through the active layer and the insulating layer into the substrate, the trench being filled with a conductive material, the conductive material being in electrical contact with the source region and the substrate.

The active layer may comprise a multilayer structure, the multilayer structure comprising a silicon layer, a silicon-germanium undoped spacer, and a silicon-germanium doped layer.

The gate insulating layer may comprise a first section separating the gate from the channel region and a second section of the gate insulating layer separating the gate from the lightly doped drain, the first section being thinner than the second section.

BRIEF DESCRIPTION OF THE DRAWINGS

**Fig. 1** is a cross-sectional view of a prior lateral MOSFET used for linear applications.

**Fig. 2** is a cross-sectional view of a MOSFET in accordance with this invention.

**Fig. 3** is a cross-sectional view of a silicon-germanium multilayer structure.

**Figs. 4A, 4B** and **4C** illustrate the steps of a process of fabricating the MOSFET of **Fig. 2**.

**Fig. 5** is a cross-sectional view of an embodiment of this invention wherein the gate oxide layer is thicker at the drain end of the gate.

**Figs. 6A, 6B** and **6C** illustrate the steps of a process of fabricating the MOSFET of **Fig. 5**.

**Figs. 7, 8, 9** and **10** are graphs that compare the performance of MOSFETs in accordance with this invention with a prior art MOSFET in linear applications.

**Figs. 11, 12, 13, 14A, 14B, 15** and **16** are graphs that compare the performance of MOSFETs in accordance with this invention with prior art MOSFETs in switching applications.

DESCRIPTION OF THE INVENTION

A lateral MOSFET according to this invention is shown in **Fig. 2**. It will be understood that **Fig. 2** is a cross-sectional view of a single cell of the MOSFET; typically a power MOSFET would contain many such cells connected in parallel to provide a significant currentcarrying capacity.

MOSFET 20 shown in **Fig. 2** is formed in a silicon-on-insulator (SOI) structure 200, which is a sandwich containing an N+ silicon substrate 202, a buried oxide (silicon dioxide) layer 204, and a relatively thin active P silicon layer 206. SOI-wafers are well known in the industry and are available from a number of sources. Typically, the active layer 206 is from 0.2 μm to 2.0 μm thick (e.g., 0.5 μm), and the oxide layer 204 is from 0.1 μm to 0.5 μm thick (e.g., 0.2 μm). Oxide layer 204 is usually grown on the silicon substrate 202 by a thermal process.

MOSFET 20 is a lateral MOSFET which includes an N+ source region 212 and a lightly doped N region 214;

and an N+ drain region 216 and a lightly doped N region 218. MOSFET 20 also includes a P body region 213. A silicon-germanium multilayer structure 230 (which is optional and is described below) is formed over P-type active layer 206. An oxide layer 232 overlying the silicon-germanium multilayer structure 230 insulates a gate electrode 210 from the silicon-germanium multilayer structure 230. A refractory silicide layer 234 covers gate electrode 210, creating what is sometimes referred to as a "polycide" structure.

The source and drain regions 212, 216 are contacted as follows. A metal contact 240 contacts drain region 216, through silicon-germanium multilayer structure 230 and through a silicide layer 242. On the other hand, source region 212 is contacted from the backside of the chip, via N+ substrate 202 and a trench 244, which extends from surface of active layer 206, through active layer 206 and buried oxide layer 204 into N+ substrate 202. Trench 244 is filled with a conductive plug 246, formed of doped polysilicon or another conductive material. The surface of plug 246 is in electrical contact with source region 212 at a portion of the side wall of trench 244 and abuts a silicide layer 248 which also establishes electrical contact with source region 212 through silicon-germanium multilayer structure 230. A passivation layer 250 formed of borophosphosilicate glass (BPSG) overlies MOSFET 20. A P+ enhancement region 207 is formed within the P active layer 206 underneath N+ source region 212 and lightly doped N region 214. P+ enhancement region 207 is shorted electrically to N+ source region 212 and conductive plug 246 via the silicide layer 248 in the third dimension, outside the plane of the drawing (not visible in **Fig. 2**).

There are a number of advantages to the structure shown in **Fig. 2**. The vertical dimension of the device is reduced by substituting the thin active layer over the buried oxide layer in place of the relatively thick epitaxial layer shown in **Fig. 1**. This in turn allows the pitch of the MOSFET cells to be reduced. The drain-to-source capacitance is also reduced. The lateral capacitive coupling between N+ drain 216/lightly doped N region 218 and N+ source 212/lightly doped N region 214 within active layer 206 is reduced because of the small cross-sectional area of active layer 206 (in a vertical cross-section). The capacitive coupling between N+ source 212/lightly doped N region 214 and N+ substrate 202 is reduced by the insulative buried oxide layer 204. The shallowness of active layer 206 and presence of the insulative buried oxide layer 204 allow N+ source 212/lightly doped N region 214 and N+ drain 216/lightly doped N region 218 to be deeper and more heavily doped without affecting the breakdown voltage of the transistor. This provides the device with a greater current carrying capacity.

The "polycide" structure for the gate provides a low gate resistance and enables the MOSFET cells, which are typically connected in parallel, to be operated at high frequencies. When the MOSFET is operated as a power switch, the product of the gate resistance and the input capacitance of the switching transistor determines a time constant which determines the on and off switching times. Reducing the gate resistance permits much faster switching, and this, in turn, reduces the switching power losses by reducing the time period during which the switched current coincides with a high voltage across the transistor.

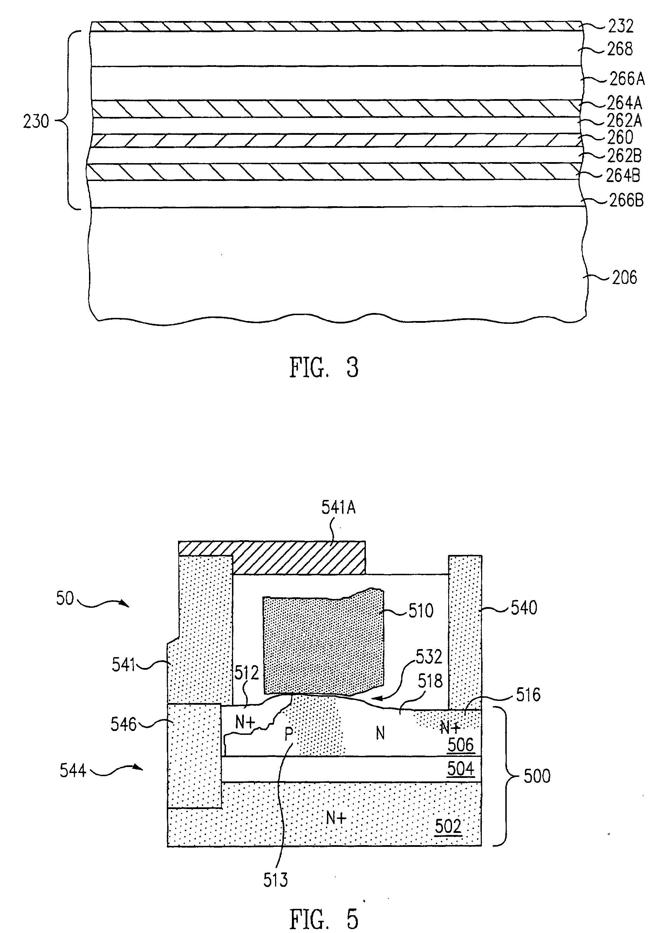

**Fig. 3** is a cross-sectional view of a section of the silicon-germanium multilayer structure 230, which is sometimes referred to as a MODFET (modulation-doped FET) structure. MODFETs are also referred to as high electron-mobility transistors (HEMTs). At the core of the structure is a silicon layer 260 which is typically a few nanometers (e. g., 9 nm) thick. Above and below silicon layer 260 are undoped silicon-germanium ($Si_{0.55}Ge_{0.45}$) spacers 262A and 262B, antimony (Sb) doped carrier supply layers 264A and 264B, and silicon-germanium buffer layers 266A and 266B. Silicon-germanium buffer layer 266B is in contact with the top surface of active layer 206. This MODFET structure is described in Procedings of the Device Research Conference (DRC) '99, pages 177-179. Directly above silicon-germanium buffer layer 266A lie a silicon capping layer 268 and a gate oxide layer 232.

Particular manufacturing processes for two types of MOSFETs according to this invention will be described. The first is an example of a process for fabricating the MOSFET 20 shown in **Fig. 2**.

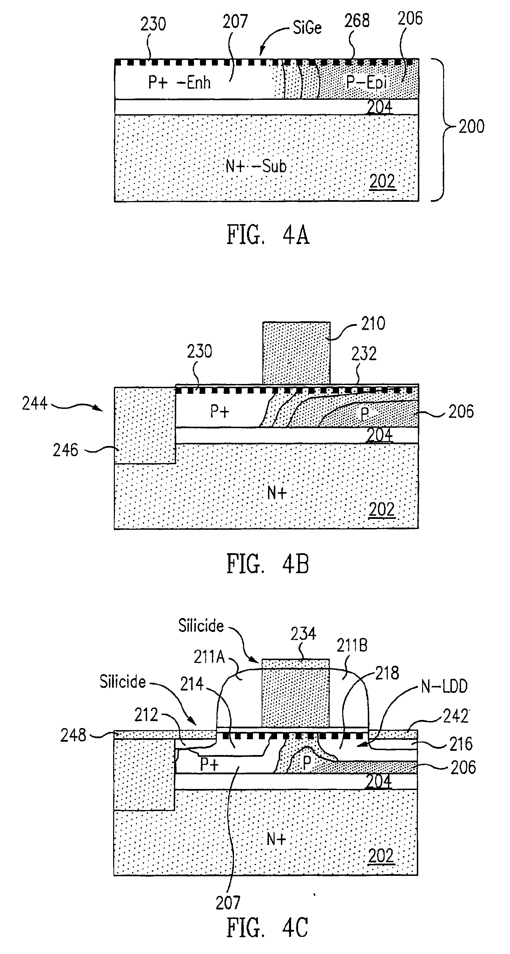

The process is illustrated in **Figs. 4A-4C**. It starts with a commercially available SOI wafer with the N+ substrate 202 doped to a concentration of $2 \times 10^{19}$ cm$^{-3}$, a buried oxide layer 204 that is 0.2 $\mu$m thick, and a P-type active layer 206 that is 0.5 $\mu$m thick and doped to a concentration of $3 \times 10^{16}$ cm$^{-3}$. A screen oxide layer 300 Å thick is grown on the surface of the active layer 206. A first mask is formed over the screen oxide layer, and boron is implanted into the active layer 206 at a dose of $5 \times 10^{13}$ cm$^{-2}$ and an energy of 150 keV. The dopant is driven-in at 1150 °C for 30 minutes to form a P+ enhancement region 207.

Optionally, the silicon-germanium multilayer structure 230 is formed on top of active layer 206, as described above and shown in **Fig. 3**. This is accomplished by the epitaxial growth of Si-Ge quantum well layers to form a 2DEG (two-dimensional electron gas) channel. Heterostructure field-effect transistors containing quantum well layers are described, for example, in S.M. Sze, *High-Speed Semiconductor Devices,* Wiley-Intersource (1990), pp. 4, 283-323, which is incorporated herein by reference. Silicon capping layer 268 is then formed .

The resulting structure is shown in **Fig. 4A**.

Next, a sacrificial oxide layer 400 Å thick is deposited on silicon capping layer 268 by low-temperature oxidation (LTO), and BF$_2$ is implanted at a dose of $1.5 \times 10^{12}$ cm$^{-2}$ and an energy of 80 keV to adjust the threshold voltage. The sacrificial oxide is stripped, and gate oxide layer 232 is thermally grown at 850 °C in steam. Gate oxide layer 232 can be 250 Å thick.

Next, a second, trench mask is formed, with an opening where trench 244 is to be located. Trench 244 is formed by reactive ion etching (RIE) through active layer 206 and buried oxide layer 204 into N+ substrate 202. Trench 244 can be 1 $\mu$m wide, for example.

N+ doped polysilicon is deposited by chemical vapor deposition (CVD) to a thickness of 0.7 $\mu$m, filling trench 244 and overflowing onto the surface of gate oxide layer 232. A third mask is formed where gate electrode 210 is to be located, and the polysilicon in the trench is etched by RIE to the level of gate oxide layer 232, forming conductive plug 246. The polysilicon is oxidized at 850 °C for 30 minutes in a dry environment. This improves the integrity of the gate oxide at the corners of the patterned polysilicon gate.

The resulting structure is shown in **Fig. 4B**.

Next, phosphorus is implanted at a dose of 2 x $10^{13}$ cm$^{-2}$ and an energy of 120 keV to form the lightly doped source-drain regions 214, 218. An LTO (low temperature oxide) layer 0.35 $\mu$m thick is deposited and the LTO is densified by annealing at 850 °C for 15 minutes in dry $O_2$. The LTO oxide is etched by RIE to form spacers 211A and 211B on the side walls of the gate electrode 210.

Optionally, a salicide (self-aligned silicide) process is performed to form silicide layers 234, 242 and 248. This can be accomplished by depositing an 80 nm thick layer of titanium by CVD, annealing the titanium layer at 650 °C in $N_2$ to form TiN, wet etching the TiN, and performing a rapid thermal process (RTP) at 850 °C.

The resulting structure is shown in **Fig. 4C**.

A fourth mask is formed with openings where the source-drain regions 212, 216 are to be located. Arsenic is implanted at a dose of 1 x $10^{15}$ cm$^{-2}$ and an energy of 60 keV to form the source and drain regions 212, 216 in the active layer 206. Sidewall spacers 211A and 211B properly align the source and drain regions with the gate electrode 210. Areas are left blocked to allow for a later P+ contact to the P+ enhancement region 207 in the third dimension (outside the plane of the paper).

Passivation layer 250 is formed by depositing BPSG to a thickness of 0.75 $\mu$m. The BPSG is reflowed using a rapid thermal process at 900 °C.

A fifth, contact mask is formed and etched by RIE to form contact windows. A contact window for the source region is formed in the third dimension.

$BF_2$ is implanted at a dose of 1 x $10^{14}$ cm$^{-2}$ and an energy of 40 keV to form a contact to the P+ enhancement region 207. The dopant is activated and the BPSG is reflowed by RTP at 900 °C.

A metal layer including 50 nm of titanium and 1 $\mu$m of aluminum is deposited, masked and etched to form metal contact 240.

This yields the structure shown in **Fig. 2**. There is a contact to the P+ enhancement region 207 and to the N+ source region 212 in the third dimension which is not visible in **Fig. 2**. This contact creates a low-resistance short between the source 212 and body 213 regions.

Thereafter, the back side of N+ substrate 202 can be ground to a thickness of, for example, 200 $\mu$m, and a back side metal layer including, for example, 130 nm of titanium, 400 nm of nickel, and 1000 nm of silver can be deposited to establish electrical contact to N+ substrate 202.

A possible problem with the embodiment of **Fig. 2** is that the electric field reaches a peak near the gate oxide on the drain side of the polysilicon gate (the righthand side in **Fig. 2**). As a result, the device may be limited to applications where the maximum drain voltage is below a specified level, e.g., 20 V. The high electric field can be alleviated by introducing a thicker gate oxide at this location.

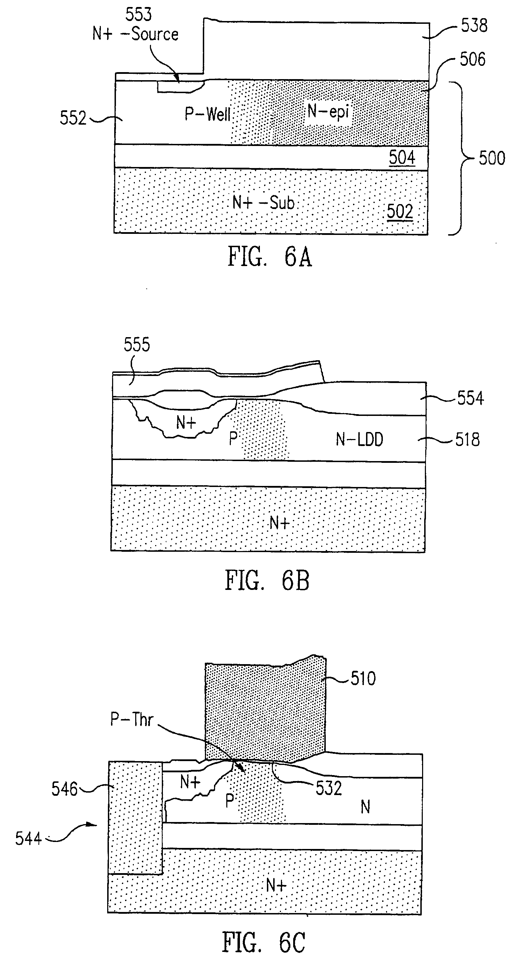

**Fig. 5** illustrates a cross-sectional view of a MOSFET which includes a thicker gate oxide layer on the drain side of the gate. MOSFET 50 is formed in an SOI substrate 500. MOSFET 50 includes an N+ source region 512, an N+ drain region 516, a lightly doped drain region 518 and a P body region 513. A trench 544 contains a conductive plug 546 which extends from the surface of the active layer 506 through the buried oxide layer 504 and into the N+ substrate 502. A metal contact 540 contacts the N+ drain region 516, and a metal contact 541 contacts the N+ source region 512 and also the top surface of conductive plug 546 and contains a section that overlies the gate 510. A gate oxide layer 532 which underlies the gate electrode 510 is thicker on the side which faces the N+ drain region 516.

**Figs. 6A-6C** illustrate a process of manufacturing MOSFET 50. Referring to **Fig. 6A**, the process begins with a commercially available SOI-wafer 500 that is similar to the SOI-wafer 200 described above except that the active layer 506 is N-type material doped to a concentration of 8 x $10^{16}$ cm$^{-3}$. An initial oxide layer 550 is grown thermally. Oxide layer 550 can be 0.5 $\mu$m thick. A first P-well mask is formed and boron is implanted, in two stages, at a dose of 1.5 x $10^{14}$ cm$^{-2}$ and an energy of 150 keV and a dose of 1 x $10^{13}$ cm$^{-2}$ and an energy of 80 keV. The boron is driven in at 1150 °C for 15 minutes to form a P-well 552.

The first mask is removed and a second N+ block mask 538 is formed. Arsenic is implanted through the second mask at a dose of 5 x $10^{15}$ cm$^{-2}$ and an energy of 60 keV to form N+ source contact region 553, leaving room at the surface in the third dimension for a later contact to the P-well 552. The resulting structure is shown in **Fig. 6A**.

Oxide layer 550 is stripped, and a pad oxide is grown thermally to a thickness of 400 Å at 900 °C in steam. A nitride layer 555 is deposited to a thickness of 0.2 $\mu$m. A third drain mask is formed, and phosphorus is implanted at a dose of 1 x $10^{11}$ cm$^{-2}$ and an energy of 220 keV to form N-type lightly doped drain (N-LLD) region 518. A local oxidation of silicon (LOGOS) process is performed at 950 °C in steam to create a field oxide region 554 that is 0.2 μm thick. The resulting structure is shown in **Fig. 6B**.

Nitride layer 555 is stripped, and a sacrificial oxide layer is grown a 950 °C in steam to a thickness of 400 Å. A threshold adjust implant of BF$_2$ is performed at a dose of 2 x $10^{12}$ cm$^{-2}$ and an energy of 80 keV, after which the sacrificial oxide layer is stripped.

Next, gate oxide layer 532 is grown to a thickness of 350 Å at 900 °C in steam. After this step, trench 544 is formed, polysilicon is deposited by CVD and RIE-etched as described above in connection with MOSFET 20, yielding the structure shown in **Fig. 6C**. The polysilicon is oxidized at 900 °C in dry O$_2$ for 30 minutes.

A sixth N+ block mask is formed and arsenic is implanted at a dose of 1 x $10^{15}$ cm$^{-2}$ and an energy of 60 keV to form drain region 516 at a desired separation from gate electrode 510.

A layer 560 of BPSG is deposited to a thickness of 0.75 μm and flowed at 900 °C for 30 minutes. A seventh contact mask is formed, and windows for metal contacts to the N+ source 512, the N+ drain 516 and the P-well 552 are opened in BPSG layer 560 by RIE etching. (The contact window for the P-well 552 is located in the third dimension.) BF$_2$ is implanted at a dose of 1 x $10^{14}$ cm$^{-2}$ and an energy of 40 keV to form a contact for the P-well region 552. The structure is annealed at 900 °C for 30 minutes to active the dopant and reflow the BPSG.

A metal layer (50 nm titanium, 1 μm aluminum) is deposited and masked and etched to form metal contacts 540 and 541 for drain region 516 and source region 512, respectively, and for the P-well 552 (in the third dimension). The metal layer is masked in such a way that a portion 541A of contact 541 overlies gate 510. The result is MOSFET 50 shown in **Fig. 5**.

Thereafter, the back side of the SOI structure can be ground and metalized as described above in connection with MOSFET 20.

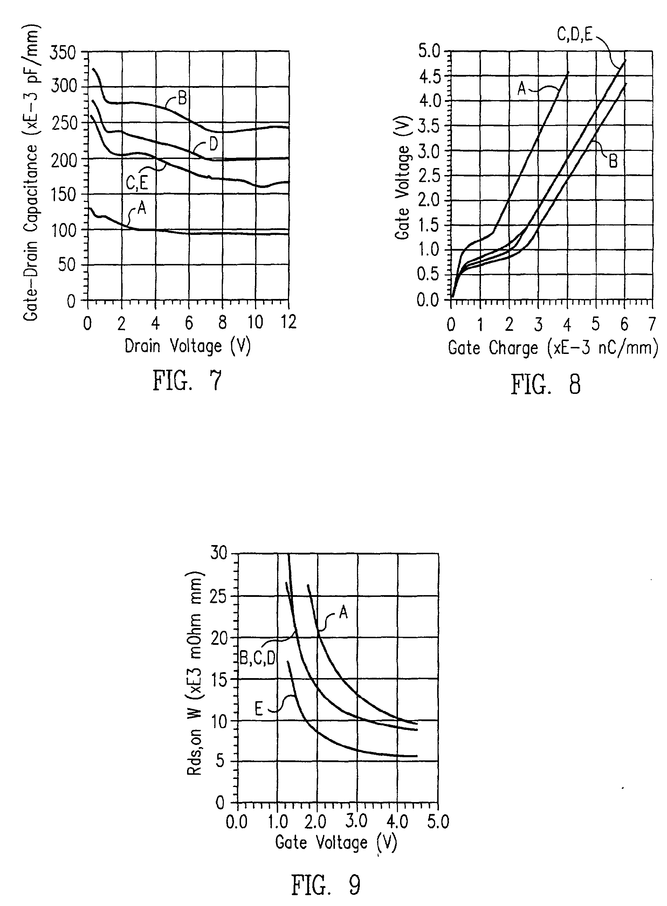

**Figs. 7-15** are graphs comparing the performance of MOSFETs according to this invention with prior art MOSFETs. Since the MOSFETs can be used either in linear amplification or power switching applications; both uses are covered.

**Figs. 7-10** illustrate characteristics relevant to the use of the MOSFET as a linear amplifier. The benchmark for this use is the high-frequency DMOS (HF-DMOS) device shown in **Fig. 1**. The comparison was between a 12 V HF-DMOS having a gate length of 0.6 μm and a gate oxide thickness of 250 Å (identified as device A) and. four 12 V N-channel SOI devices of the kind shown as MOSFET 20 in **Fig. 2** (identified as devices B, C, D and E). Each of the 12 V SOI devices also had a gate length of 0.6 μm and a gate oxide thickness of 250 Å. Device B had an overlay of drain metal covering the gate; device C had an overlay of source metal covering the gate; device D had no metal overlying the gate; and device E had an overlay of source metal covering the gate as well as a silicon-germanium multilayer structure.

**Fig. 7** shows the gate-drain capacitance as a function of gate voltage. **Fig. 8** shows the gate voltage as a function of the gate charge. **Fig. 9** shows the on-resistance Rds,on as a function of the gate voltage.

Table 1 shows additional data concerning devices A, B, C, D and E.

Table 1

|   | Ciss/W | Coss/W | Vth0 | Rds,onW | Qg/W | Rds, onQg | Pitch |
|---|--------|--------|------|---------|------|-----------|-------|
| A | 473 | 486 | 1.0 | 15.4 | 2.4 | 37 | 8.1 |
| B | 566 | 414 | 0.9 | 11.7 | 4.1 | 48 | 2.7 |
| C | 564 | 315 | 0.9 | 11.9 | 3.7 | 44 | 2.7 |
| D | 534 | 331 | 0.9 | 11.6 | 3.7 | 43 | 2.7 |
| E | 564 | 315 | 0.9 | 7.6 | 3.7 | 28 | 2.7 |

The capacitances Ciss and Coss were calculated at Vds = 12 V and expressed in $10^{-3}$ pF/mm. The on-resistance Rds,on is at Vgs = 2.5 V and is expressed in $10^3$ mOhm mm. The gate charge Qg is at Vgs = 2.5 V and is expressed in $10^{-3}$ nC/mm. The pitch is expressed in microns.

These data show that the compared devices have a similar value of a figure of merit based on the product of the on-resistance Rds,on and the gate charge Qg at a specific gate voltage (here Vgs = 2.5 V0. However, for linear applications such as signal amplifiers the transconductance gm (Ids) and related figures of merit are more significant. The transconductance calculated at the operation point Vds = 1/2Vds,max should have a high value and stay constant throughout a wide range of output currents (Ids). The output current at which the transconductance drops from its maximum value by 10% defines the maximum usable current (Ids,m) for a linear amplifier.

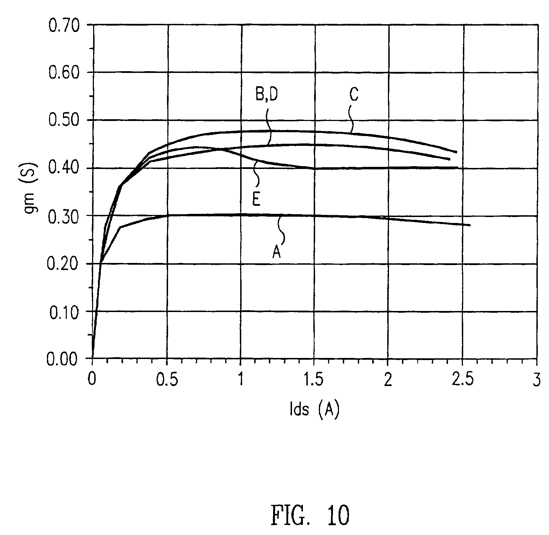

**Fig. 10** shows the transconductance as a function of the output current for the devices referred above.

Table 2 shows relevant data for devices A-E.

Table 2

|  | gmax/W mS/mm | Vgs V | Ids/W A/mm | Ids,m/W A/mm | W(2.5A) mm | fm GHz |
|---|---|---|---|---|---|---|
| A | 46 | 6.0 | 0.21 | 0.38 | 6.6 | 15.4 |
| B | 74 | 4.5 | 0.25 | 0.41 | 6.1 | 20.9 |
| C | 81 | 3.5 | 0.18 | 0.43 | 5.8 | 22.8 |
| D | 74 | 4.5 | 0.25 | 0.41 | 6.1 | 22.0 |
| E | 100 | 2.5 | 0.14 | 0.57 | 4.4 | 28.2 |

The maximum frequency fm is defined as follows.

$$fm = \frac{Ids,\, \max}{2\pi Ciss}$$

Here the superiority of the devices according to the invention becomes apparent. Devices B, C, D and E exhibit a higher value of maximum transconductance per mm of channel width (gmax/W). This maximum occurs at a lower gate voltage (Vgs) and remains constant over a larger range of currents, leading to a larger Ids, m/W. The resulting channel width for a maximum current of 2.5 A is smaller and the theoretical maximum operation frequency (fm) is significantly higher.

Device E, containing the silicon-germanium multilayer structure performed the best, but even device C, a MOSFET without a silicon-germanium multilayer but with the source metal overlying the gate, performed substantially better than the prior art device A.

In the field of power switching there are two types of MOSFETs competing in the market: a planar DMOS transistor with a vertical current flow (VDMOS) and a trench MOSFET. **Figs. 11-16** compare the performance of these prior art devices with MOSFETs of this invention. In these figures, the following designations are used:

Device F is an N-channel VDMOS having a gate oxide thickness of 300 Å.
Device G is an N-channel trench MOSFET having a gate oxide thickness of 500 Å.
Device H is an N-channel SOI transistor of this invention having a gate oxide thickness of 350 Å.
Device I is an N-channel SOI transistor of this invention including a silicon-germanium multilayer structure.

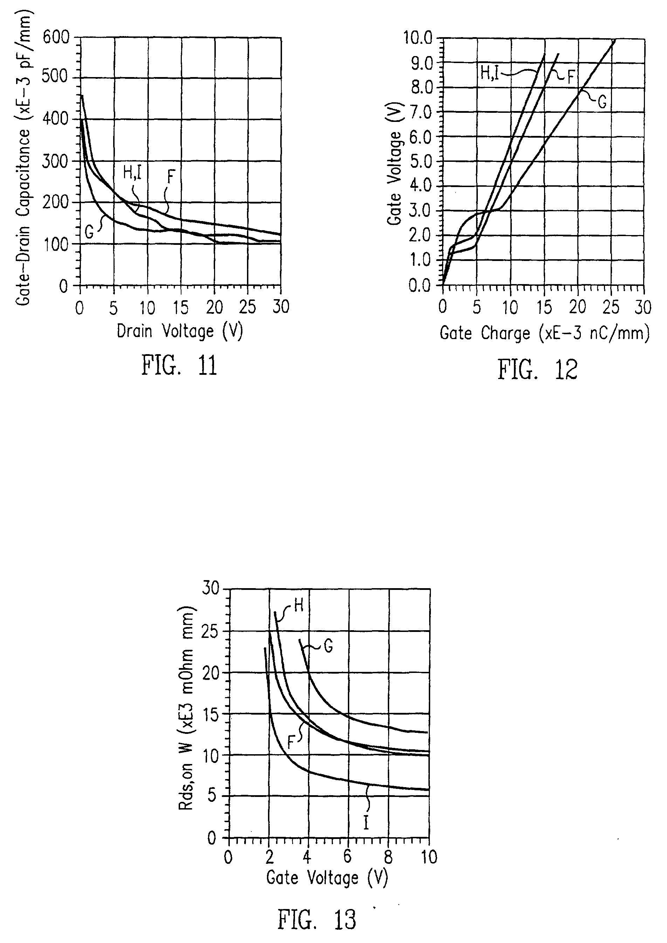

**Fig. 11** shows the gate-drain capacitance as a function of drain voltage. **Fig. 12** shows the gate voltage as a function of gate charge. **Fig. 13** shows the on-resistance as a function of gate voltage.

Table 3 shows further data concerning devices F-I.

Table 3

|  | Ciss/W | Coss/W | Vth0 | Rds, onW | Qg/W | Rds, onQ g | Pitch |
|---|---|---|---|---|---|---|---|
| F | 686 | 296 | 1.1 | 13.2 | 9.8 | 179 | 3.0 |
| G | 1473 | 170 | 2.4 | 17.8 | 12 | 214 | 2.4 |
| H | 734 | 232 | 0.8 | 13.7 | 9 | 123 | 3.3 |
| I | 734 | 232 | 0.8 | 7.7 | 9 | 69 | 3.3 |

In Table 3, the capacitances Ciss and Coss are calculated at Vds = 30 V and expressed in $10^{-3}$ pF/mm. The on-resistance Rds,on is calculated for Vgs = 4.5 V and expressed in $10^3$ mOhm mm. The gate charge Qg is calculated at Vgs = 4.5 V and expressed in $10^{-3}$ nC/mm. The SOI transistors, devices H and I, have a significantly lower product of Rds,on and Qg, which is beneficial for switching applications.

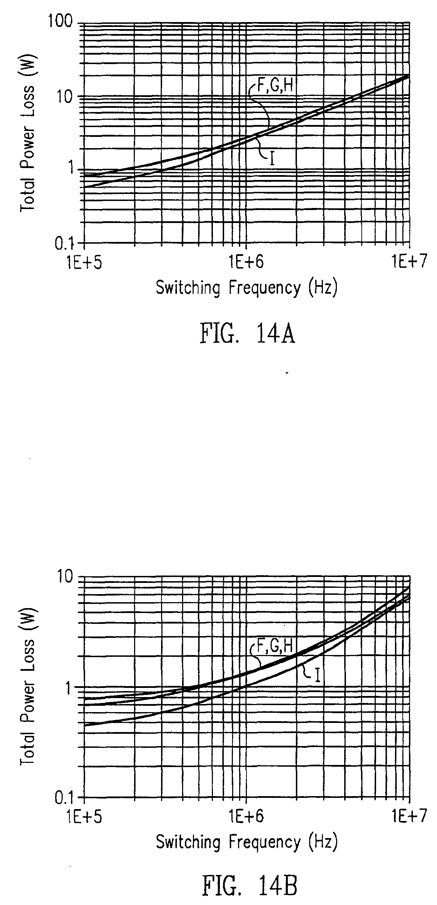

**Figs. 14A** and **14B** show the total power losses calculated as a function of switching frequency in devices F-I. **Fig. 14A** describes a device with a polysilicon gate and **Fig. 14B** describes a device in which the gate contains a layer of silicide on top of the polysilicon.

Referring to **Fig. 14A**, device I, the device with a silicon-germanium multilayer, shows lower power losses than the other devices at frequencies below 1 Mhz. This result is significant, because until now the operating frequency of DC-DC converters has been limited by the power losses of the switching transistors to frequencies below 500kHz.

Putting a silicide on top of the polysilicon gate decreases the switching constant (RgCiss), and faster switching leads to lower switching losses (the losses still increase with frequency). **Fig. 14B** indicates that a device with a "polycide" gate in combination with a silicon-germanium channel provides superior performance. The use of such a device would allow the frequency of a DC-DC convertor to be increased to the range of 3 MHz, allowing small filter components to be used.

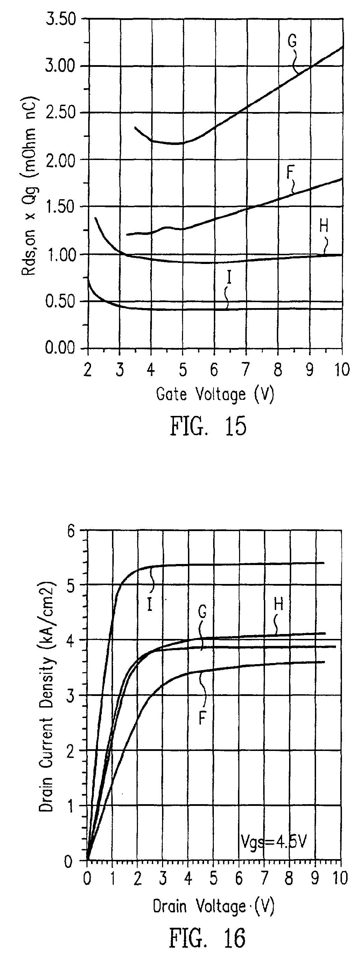

**Figs. 15** and **16** summarize other important parameters of power switching transistors. **Fig. 15** shows the product of the on-resistance Rds,on and the gate charge Qg as a function of the gate voltage. **Fig. 16** shows the density of the drain current as a function of the drain voltage at a gate voltage of 4.5 V.

Table 4 shows relevant parameters for devices with a polysilicon gate.

Table 4

| | Rds A mOhm cm$^2$ | Cgd/A nF/cm$^2$ | Im, out/A kA/cm$^2$ | P(3MHz) W | fm MHz |
|---|---|---|---|---|---|
| F | 0.39 | 4.0 | 3.3 | 6.3 | 54 |
| G | 0.42 | 4.4 | 3.7 | 6.3 | 38 |
| H | 0.25 | 2.9 | 3.9 | 5.7 | 58 |
| I | 0.23 | 2.9 | 5.2 | 5.5 | 56 |

The specific resistance and gate capacitance are calculated at Vgs = 4.5 V. Im,out is defined by extrapolating the drain current from the saturation region to an intercept with the y-axis in **Fig. 16**. The total power loss at 3 MHz (P(3MHz)) is estimated according to a simplified model for calculating the switching times. The active area of the switching transistor has been set to 5 mm$^2$ and the external resistance of the gate circuit to 1 Ohm. One over the sum of the switching times defines a maximum switching frequency (fm).

Table 5 shows the power losses at 3 Mhz and the maximum switching frequency for devices with contain a polycide gate.

Table 5

| | P (3MHz) | fm(MHZ) |
|---|---|---|
| F | 2.9 | 150 |
| G | 2.9 | 105 |
| H | 2.6 | 160 |
| I | 2.4 | 155 |

As shown, the SOI transistor containing a silicon-germanium multilayer and a polycide gate exhibits the lowest Rds Qg product, can deliver a very high current, and shows the lowest power loses at 3 MHz.

While specific embodiments of this invention have been disclosed, it will be apparent that numerous alternative embodiments can be constructed using the principles of this invention.

**Claims**

1. A MOSFET comprising:

   a sandwich comprising an active semiconductive layer, an insulating layer, and a semiconductor substrate of a first conductivity type, the insulating layer being interposed between the active layer and the substrate;
   the active layer comprising a body region of a second conductivity type and source and drain regions of the first conductivity type, a channel region of the body region being interposed between the source and drain regions;
   a gate overlying the channel region, the gate being separated from the channel region by a gate insulating layer; and
   a trench extending from the surface of the active layer through the active layer and the insulating layer into the substrate, the trench being filled with a conductive material, the conductive material being in electrical contact with the source region and the substrate.

2. The MOSFET of Claim 1 wherein the active layer comprises a silicon-germanium multilayer structure, the multilayer structure comprising a silicon layer, a silicon germanium undoped spacer, and a silicon-germanium doped layer.

3. The MOSFET of Claim 1 comprising a lightly doped drain region interposed between the drain region and the channel region.

4. The MOSFET of Claim 3 wherein the gate overlies at least a portion of the lightly doped drain region, a first section of the gate insulating layer separating the gate from the channel region being thinner than a second section of the gate insulating layer separating the gate from the lightly doped drain.

5. The MOSFET of Claim 4 comprising a nonconductive layer overlying the gate, a first metal contact extending through the nonconductive layer and being in electrical contact with the drain region, a second metal contact extending through the nonconductive layer and being in electrical contact with the source region, a portion of the second metal contact overlying the gate.

6. The MOSFET of Claim 5 wherein the second metal contact is in physical contact with the conductive material in the trench.

7. The MOSFET of Claim 1 comprising a silicide layer in electrical contact with the source region and the conductive material in the trench.

8. Tne MOSFET of Claim 1 comprising an enhancement region within the body region, the enhancement region being doped to the second conductivity type more heavily than another portion of the body region.

9. The MOSFET of Claim 1 comprising a silicide layer over the gate.

10. A method of fabricating a MOSFET comprising:

> providing a sandwich comprising an active semiconductive layer of a first conductivity type, an insulating layer, and a semiconductor substrate of a second conductivity type, the insulating layer being interposed between the active layer and the substrate;
> forming a first mask over the active layer;
> implanting dopant of the first conductivity type into the active layer through an opening in the first mask to form an enhancement region of the first conductivity type in the active layer;
> forming a second mask over the active layer;
> etching through an opening in the second mask to form a trench in the sandwich, the trench extending through the active layer and the insulating layer and into the semiconductor substrate;
> depositing a conductive material in the trench;
> forming a gate oxide layer on a surface of the active layer; and
> forming a gate over the gate oxide layer; and
> implanting dopant of the second conductivity type into the active layer to form source and drain regions located on opposite sides of the gate.

11. The method of Claim 10 comprising forming sidewall spacers on the gate before implanting dopant of the second conductivity type into the active layer to form the source and drain regions.

12. The method of Claim 10 wherein forming the source region comprises implanting dopant of the second conductivity type in a location adjacent to the trench.

13. The method of Claim 10 comprising depositing a layer of borophosphosilicate glass and opening source and drain contact windows in the layer of borophosphosilicate glass.

14. The method of Claim 13 comprising opening a third contact window in the layer of borophosphosilicate glass, the third window overlying the enhancement region.

15. The method of Claim 14 comprising forming metal contacts in the contact windows.

16. The method of Claim 10 wherein depositing a conductive material in the trench and forming a gate comprise:

depositing a polysilicon layer over the active layer, the polysilicon layer filling the trench and covering at least a portion of the active layer outside the trench;

forming a third mask over the polysilicon layer at a location where the gate is to be located; and

etching the polysilicon layer except for the portion of the polysilicon layer underlying the third mask such that a surface of the polysilicon layer in the trench is at a level near the top surface of the active layer.

**17.** A method of fabricating a MOSFET comprising:

providing a sandwich comprising an active semiconductive layer of a first conductivity type, an insulating layer, and a semiconductor substrate of the first conductivity type, the insulating layer being interposed between the active layer and the substrate;

forming a first mask over the active layer;

implanting dopant of a second conductivity type into the active layer through an opening in the first mask to form a well of the second conductivity type in the active layer;

forming a second mask over the active layer, the second mask having an opening located over the well;

implanting dopant of through the opening in the second mask to form a source contact region of the first conductivity type;

forming a pad oxide at a surface of the active layer;

forming a nitride layer over a portion of the pad oxide;

performing a local oxidation of silicon (LOCOS) process to form a field oxide region;

removing the nitride layer and the pad oxide layer;

forming a gate oxide layer over the active layer

forming a third mask over the active layer;

etching through an opening in the third mask to form a trench in the sandwich, the trench extending through the active layer and the insulating layer and into the semiconductor substrate;

depositing a conductive material in the trench;

forming a gate oxide layer on a surface of the active layer; and

forming a gate over the gate oxide layer, a portion of the gate overlying the field oxide region; and

implanting dopant into the active layer to form a drain region of the second conductivity type located on an opposite side of the gate from the source region.

**18.** The method of Claim 17 comprising:

depositing a layer of borophosphosilicate glass over the active layer and the gate;

opening first and second contact windows in the layer of borophosphosilicate glass, the first contact window overlying the drain region, the second contact window overlying the trench; and

forming metal contacts in the contact windows.

FIG. 1
(PRIOR ART)

FIG. 2

232
268
266A
264A
262A
230
260
262B
264B
266B

206

FIG. 3

541A

50
510
540
541
532
512
518
516
546
N+        P        N        N+
506
544
504
500
N+        502

513

FIG. 5

230     207     SiGe     268     206

P+ –Enh           P–Epi

204

N+ –Sub     202

200

## FIG. 4A

210

230           232

244

P+           P     206

246

204

N+     202

## FIG. 4B

Silicide

234     211B

211A     218

Silicide     214     N–LDD

212           242

248           216

P+     P     206

204

N+     202

207

## FIG. 4C

FIG. 6A

FIG. 6B

FIG. 6C

FIG. 7

FIG. 8

FIG. 9

FIG. 10

FIG. 11

FIG. 12

FIG. 13

FIG. 14A

FIG. 14B

FIG. 15

FIG. 16